(19) Europäisches Patentamt
European Patent Office
Office européen des brevets

(11) **EP 0 926 810 B1**

(12) **FASCICULE DE BREVET EUROPEEN**

(45) Date de publication et mention
de la délivrance du brevet:
**30.07.2008 Bulletin 2008/31**

(51) Int Cl.:
*H02P 9/30* *(2006.01)*        *G01R 19/00* *(2006.01)*

(21) Numéro de dépôt: **98403260.7**

(22) Date de dépôt: **22.12.1998**

(54) **Perfectionnement aux régulateurs d'alternateur polyphasés de véhicule**

Verbesserung für mehrphasige Fahrzeuggeneratorregler

Improvement for polyphase vehicle generator controllers

(84) Etats contractants désignés:
**DE ES GB IT**

(30) Priorité: **24.12.1997 FR 9716496**

(43) Date de publication de la demande:
**30.06.1999 Bulletin 1999/26**

(73) Titulaire: **VALEO EQUIPEMENTS ELECTRIQUES MOTEUR**
**94000 Créteil (FR)**

(72) Inventeur: **Pierret, Jean-Marie**
**75012 Paris (FR)**

(56) Documents cités:
**FR-A- 2 343 255        FR-A- 2 678 070**
**FR-A- 2 730 359**

**Description**

La présente invention est relative aux régulateurs d'alternateur de véhicule automobile.

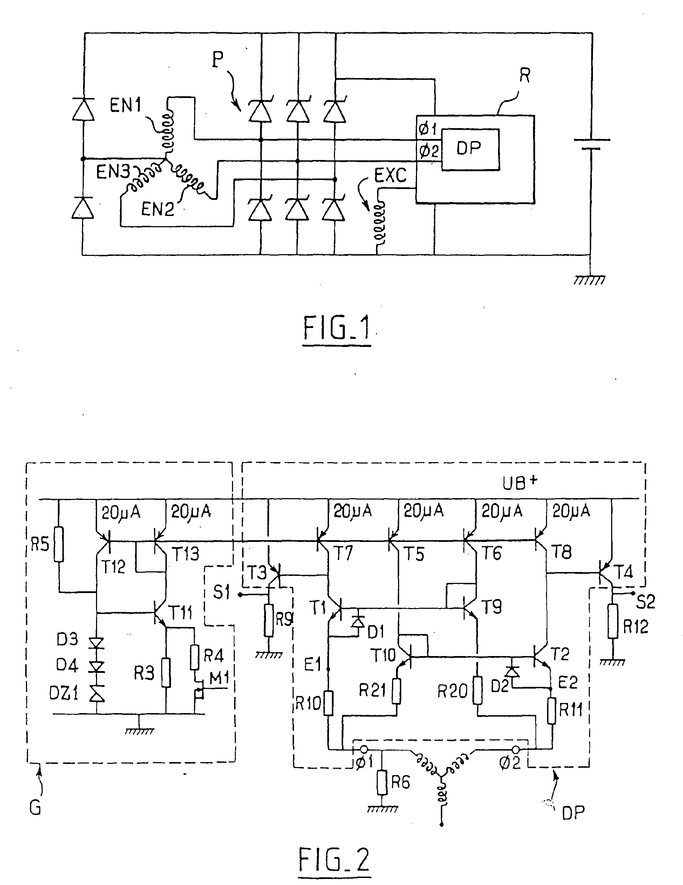

On a représenté schématiquement sur la figure 1 un circuit d'alternateur triphasé conventionnel. Ce circuit comporte notamment trois enroulements d'induit d'alternateur EN1, EN2, EN3 montés en étoile, un pont redresseur P constitué de trois paires de diodes et un régulateur R présentant deux entrées de phase φ1 et φ2 recevant deux des trois potentiels de phase des enroulements d'induit EN1, EN2, EN3.

Classiquement, ce régulateur R comporte un circuit DP pour détecter l'apparition d'une tension entre les deux bornes de phase φ1 et φ2 lors de la mise en rotation de l'alternateur et déclencher la régulation de la tension de la batterie lorsque cette mise en rotation est ainsi détectée. Un tel circuit DP permet d'assurer l'auto-amorçage de l'alternateur.

De nombreux montages pour la détection d'une tension entre des bornes de phases d'un alternateur sont déjà connus. On pourra par exemple à cet égard avantageusement se référer aux brevets et demandes de brevet FR-2.343.255, FR 2.730.359 ou FR-2.678.070.

Les montages décrits dans FR-2.343.255 et FR-2.730.359 présentent l'avantage de sensibilités de détection intéressantes (50 mV notamment).

Mais il est apparu souhaitable aux inventeurs, notamment pour tester les régulateurs lors de leur fabrication ou avant leur montage, de pouvoir appliquer sur les entrées de phase φ1 et φ2 des niveaux de potentiels différents des niveaux de potentiels reçus sur ces entrées lorsque l'alternateur fonctionne, et notamment de pouvoir appliquer sur ces entrées de phases des niveaux de potentiels fortement négatifs.

En particulier, les inventeurs proposent, dans une demande de brevet déposée le même jour que la présente demande d'intégrer, à un régulateur des moyens pour détecter ce niveau particulier de potentiel sur au moins une borne de phase et pour déclencher un fonctionnement du régulateur selon un mode accéléré lorsque ce niveau de potentiel est détecté. On dispose alors, sans qu'il ne soit nécessaire de prévoir sur le régulateur des broches d'entrée supplémentaires, d'un régulateur qu'il est possible de tester en mettant en oeuvre un déroulement selon un mode accéléré de fonctions dudit régulateur (temporisation au démarrage, charge progressive, etc.), qui, sinon, en fonctionnement normal du régulateur, se déroulent sur plusieurs secondes.

Or, les montages décrits dans FR-2.343.255 et FR-2.730.359 ne permettent pas une détection d'une différence de potentiel entre leurs deux entrées lorsque celles-ci sont portées à des potentiels fortement négatifs.

Dans le montage décrit dans FR-2.343.255, les transistors des sources de courant se bloquent lorsque des potentiels négatifs sont appliqués sur les deux entrées du montage.

Dans celui décrit FR-2.730.359, la précision se dégrade fortement lorsque les potentiels des entrées du montage débordent des valeurs de tension d'alimentation de l'alternateur.

On connaît déjà par FR-2.678.070 un montage de détection apte à fonctionner même lorsque des potentiels fortement négatifs sont appliqués sur ces deux entrées de phases φ1 et φ2.

Toutefois, ce montage ne permet au mieux qu'un niveau de détection de 600 mV, ce qui est insuffisant pour permettre un auto-amorçage à basse vitesse de rotation des alternateurs.

Un but de l'invention est donc de proposer un montage de détection qui d'une part est d'une grande sensibilité (200 mV ou inférieur : 50mV) et qui d'autre part est apte à fonctionner indépendamment du niveau de potentiel sur les entrées de phase et en particulier avec des niveaux de potentiels sur les entrées de phases fortement négatifs (de l'ordre de 10 Volts en dessous de la masse, par exemple).

A cet effet, l'invention propose un régulateur d'alternateur polyphasé de véhicule automobile comportant des moyens pour détecter une tension entre des bornes de phase destinées à recevoir des potentiels de phase dudit alternateur, caractérisé en ce que lesdits moyens de détection comportent au moins un montage de transistors formant miroir de courant dont les deux branches sont à une extrémité respectivement reliées à l'une et l'autre des deux bornes de phase et sont alimentées à leur autre extrémité par des transistors formant sources de courant qui délivrent dans lesdites branches des courants de même intensité, les deux branches présentant en outre des résistances de valeurs différentes, de sorte que l'un des transistors des montages formant sources de courant se limite sur une valeur de courant prédéterminée lorsqu'une différence de potentiel supérieure à un seuil donné apparaît entre les deux bornes de phase, cette limitation entraînant le changement de niveau d'une sortie logique commandée par le potentiel en un point de ladite branche entre le transistor formant source de courant et le transistor du montage formant miroir de courant.

Un tel régulateur est avantageusement complété par les différentes caractéristiques suivantes prises seules ou selon toutes leurs combinaisons possibles :

- il comporte deux sorties logiques et en ce que lesdits montages de transistors formant miroir et sources de courant sont dédoublés pour entraîner le changement de niveau de l'une ou l'autre desdites sorties logiques selon le sens de la différence de potentiel entre les bornes de phase.
- le niveau de détection que permettent lesdits moyens est de 200 mV ou inférieur.

- la résistance sur la branche du montage formant miroir de courant dont un potentiel commande la sortie logique est égale à 20 KΩ, la résistance sur l'autre branche étant égale à 10 KΩ.
- la résistance sur la branche du montage formant miroir de courant dont un potentiel commande la sortie logique est égale à 10 KΩ le niveau de détection que permettent les moyens de détection est de l'ordre de 50 mV.
- la résistance sur la branche du montage formant miroir de courant dont un potentiel commande la sortie logique est égale à 5 KΩ, la résistance sur l'autre branche étant égale à 2,5 KΩ.
- la résistance sur la branche du montage formant miroir de courant dont un potentiel commande la sortie logique est égale à 2,5 KΩ le régulateur comporte des moyens pour modifier le niveau de détection de la tension entre les bornes de phase lorsque le potentiel reçu sur lesdites bornes est supérieur à une valeur donnée.

D'autres caractéristiques et avantages de l'invention ressortiront encore de la description. Cette description est purement illustrative et non limitative et doit être lue en regard des dessins annexés sur lesquels :

- La figure 1 est une représentation schématique d'un circuit d'alternateur triphasé conventionnel.
- La figure 2 est un schéma d'un montage possible pour les moyens de détection de la tension entre des bornes de phase d'un régulateur conforme à un mode de réalisation possible de l'invention.
- La figure 3 est illustre un exemple de signaux en entrée et en sortie du montage de la figure 2 lorsque l'alternateur entre en rotation.
- La figure 4 est un schéma d'un autre montage possible pour l'invention.
- La figure 5 est un graphe sur lequel on a porté les signaux de phase en sortie des enroulements d'induit de l'alternateur, lorsque le régulateur est sous charge.

Un exemple de circuit de détection DP conforme à un mode de réalisation de l'invention et capable de fonctionner avec des valeurs de crêtes fortement négatives ( - 10 volts par rapport au potentiel de masse) est illustré sur la figure 2.

Ce circuit comprend deux miroirs de courant montés entre les bornes φ1 et φ2 et constitués l'un par deux transistors NPN T1, T9, l'autre par deux transistors NPN T2, T10.

Plus particulièrement, la borne φ1 est reliée via une résistance R10 à l'émetteur (point E1) du transistor T1 et par une résistance R21 à l'émetteur du transistor T10. La borne φ2 est reliée par une résistance R11 à l'émetteur du transistor T2 et par une résistance R20 à l'émetteur du transistor T9. Les bases des transistors T2 et T10 sont reliées entre elles. Il en est de même des bases des transistors T1 et T9.

Les résistances R10 et R11 sont d'une valeur supérieure à celle des résistances R20 et R21.

Des diodes D1 et D2 sont montées entre l'émetteur et la base des transistors T1 et T2 pour protéger lesdits transistors contre l'inversion de polarité des jonctions émetteur-base.

Les collecteurs des transistors T1, T10, T9 et T2 sont reliés aux collecteurs de transistors PNP T7, T5, T6 et T8 dont les bases sont reliées entre elles et dont les émetteurs sont reliés à une ligne d'alimentation sous une tension UB+ elle-même reliée au pâle positif de la batterie du véhicule.

Par ailleurs, le circuit comporte deux bornes de sortie logique S1 et S2.

La borne S1 est reliée au collecteur d'un transistor PNP T3, dont la base est reliée aux collecteurs des transistors T1 et T7. L'émetteur de ce transistor T3 est relié à la ligne UB+. La borne de sortie logique S1 est par ailleurs reliée à la masse par l'intermédiaire d'une résistance R9. De la même façon, la borne S2 est reliée au collecteur d'un transistor PNP T4, dont la base est reliée aux collecteurs des transistors T2 et T8 tandis que son émetteur est relié à la ligne UB+. La borne de sortie logique S2 est elle-même reliée à la masse par l'intermédiaire d'une résistance R12.

On notera que les résistances R9 et R12 ne font pas partie du détecteur proprement dit : elles servent de résistances de charge des étages de sortie du détecteur constitué par les transistors T3 et T4.

Egalement, le circuit de détection représenté sur la figure 2 comporte un générateur de courant G. Ce générateur G comprend une résistance R5 de forte valeur montée entre la ligne UB+ et la base d'un transistor T11 NPN. Ladite base du transistor T11 est reliée à la masse par l'intermédiaire de deux diodes D3 et D4 de compensation thermique en série avec une diode Zener DZ1. L'émetteur du transistor T11 est relié à la masse par l'intermédiaire d'une résistance R3, ainsi que par l'intermédiaire d'un sous circuit qui comporte en série une résistance R4 et un transistor M1 de type MOSFET, dont la commande sera explicitée plus loin de façon détaillée.

Le collecteur et la base du transistor T11 sont reliés respectivement au collecteurs des transistors T13 et T12 de type PNP montés en miroir de courant. Les bases des transistors T13 et T12 sont reliées aux bases des transistors T5 à T8, tandis que leurs émetteurs sont reliés à la ligne UB+.

Comme on l'aura compris, ce mode de réalisation reprend des éléments du détecteur décrit dans FR-2.678.070. On y retrouve les transistors T1, T2, T3, T4 et les résistances R10 et R11. Les résistances R7 et R8 y sont remplacées par les transistors T7 et T8 fonctionnant en source de courant.

Comme le détecteur décrit dans FR-2.678.070, le détecteur représenté sur la figure 2 ne comporte pas de potentiel de masse et les entrées phases φ1 et φ2 peuvent avoir toutes les valeurs inférieures au potentiel $U_B^+$ sans affecter le niveau de détection (200 mV ou inférieur).

La résistance R6 sert à polariser l'induit de l'alternateur lorsque celui-ci est à l'arrêt. La valeur de cette résistance R6 est suffisamment forte pour ne pas empêcher l'application du potentiel fortement négatif sur les entrées phases φ1 et φ2 (- 10 volts par rapport à la masse).

Le détecteur DP fonctionne de la façon suivante : le transistor T11 délivre un courant (20 μA) calibré par la résistance R3 et les diodes D3, D4 et DZ1. Les diodes D3 et D4 compensent thermiquement la jonction émetteur-base de T11 et la tension zener de DZ1.

On suppose dans un premier temps que le transistor M1 est ouvert.

Le courant délivré par le transistor T11 est recopié dans un rapport 1 (20 μA) par les transistors T12 et T5 à T8.

Les courants issus de T5 et T6 (20μA) traversent les transistors T9 et T10.

Lorsque l'alternateur est à l'arrêt, les deux branches du détecteur sont à l'équilibre puisque le potentiel de la phase φ2 est identique au potentiel de la phase φ1. T1 recopie le courant dans T9 et T2 recopie le courant dans T10.

Cependant, les résistances R10 et R11 étant d'une valeur supérieure à celle des résistances R20 et R21, les courants recopiés par T1 et T2 sont inférieurs aux courants dans T9 et T10. Lorsque l'alternateur est de l'ordre de 12μA alors que le courant dans T9 et dans T10 est de 20μA.

En conséquence, les transistors T7 et T8 saturent et les transistors T3 et T4 sont ouverts. Les sorties S1 et S2 du détecteur sont donc portées au potentiel de masse.

Par contre, lorsque l'alternateur est en rotation, la f.e.m. entre φ1 et φ2 déséquilibre les deux branches du détecteur et les courants dans T1 et T2 ne sont plus fixés à 12 μA. Si le potentiel de φ1 décroît par rapport au potentiel de φ2, le courant dans R10 et T1 augmente et devient supérieur à 20 μA. Le transistor T7 désature et la base de T3 est alimentée. T3 est alors passant et le potentiel de S1 est positif par rapport à la masse. De même, si le potentiel de φ2 décroît par rapport au potentiel de φ1, le courant dans T2 dépasse 20 μA et le potentiel de S2 devient positif par rapport à la masse.

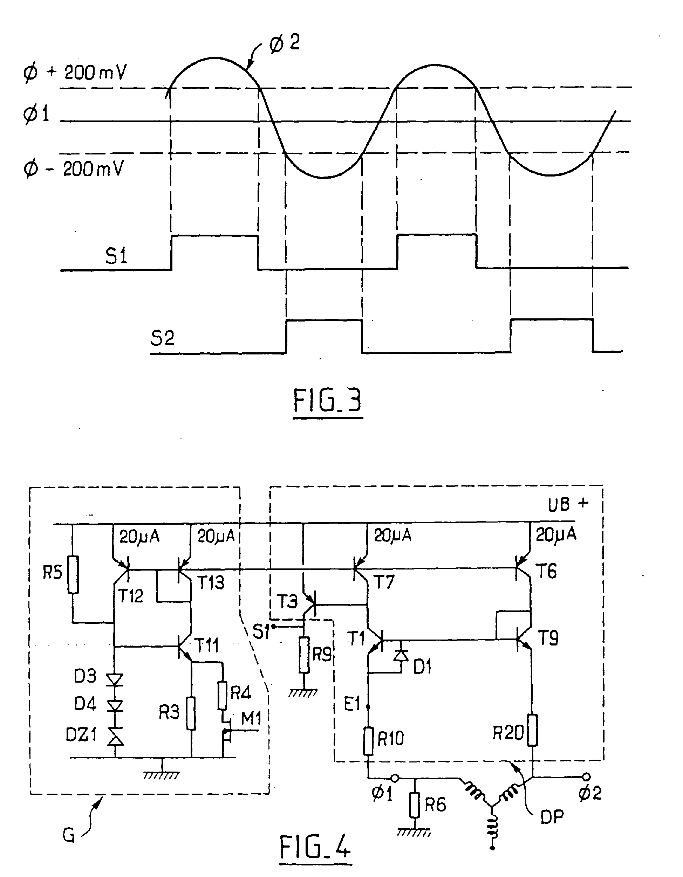

La figure 3 représente la variation de tension sur les sorties S1 et S2 lorsque le potentiel de φ2 varie d'une façon sinusoïdale par rapport à φ1. Ceci correspond à la f.e.m. produite par la rémanence du circuit magnétique de l'inducteur lorsque l'alternateur entre en rotation.

Le niveau de détection d'une différence de potentiels entre les bornes φ2 et φ1 est préférentiellement de 200 mV ou inférieur. Ce niveau de détection de 200 mV entre phases permet l'auto-amorçage de l'alternateur à basse vitesse de rotation (< 1000 tours/mn) sans courant d'excitation initial.

On démontre qu'une sensibilité de détection de 200 mV est obtenue pour des valeurs des résistances R10 et R11 choisies égales à 20 KΩ et des valeurs de résistances pour R21 et R20 égales à 10 KΩ.

En particulier, avec des détecteurs de tension du type de celui qui vient d'être décrit, on a au moment de la détection

$$V_{BE}(T1) = V_{BE}(T9)$$

et

$$V_{BE}(T2) = V_{BE}(T10)$$

où $V_{BE}(T1)$, $V_{BE}(T2)$, $V_{BE}(T9)$, $V_{BE}(T10)$ sont les tensions de jonction émetteur-base de T1 et T9 d'une part et T2, T10 d'autre part.

Les bases de T1 et T9 étant reliées, les potentiels des émetteurs de T1 et T9 sont identiques au moment de la détection, car à cet instant, les courants sont identiques (20μA) dans T1 et T9 ; T2 et T10 (il reste un décalage résiduel de 2 à 3 mV : tension d'offset).

Il est donc possible de réduire fortement les valeurs des résistances R10, R11, R20 et R21 afin de réduire fortement le niveau de détection. Si on veut détecter une différence de potentiel de 50 mV entre φ1 et φ2, on peut adopter les valeurs suivantes :

$$R21 = R20 = 2,5 \ K\Omega$$

$$R10 = R11 = 5 \ K\Omega$$

En variante, encore, Il est possible de calculer les valeurs de R10 et de R11 pour que les émetteurs de T9 et de T10 soient reliés directement respectivement à $\phi$2 et $\phi$1.

Pour un niveau de détection de 200 mV, on a $\phi$2 et $\phi$1:

$$R10 = R11 = 10\ K\Omega$$

Pour un niveau de détection de 50 mV, on a :

$$R10 = R11 = 2,5\ K\Omega$$

En pratique, il est préférable de conserver les résistances R20 et R21 lorsqu'il faut protéger les transistors T9 et T10 contre les surtensions transitant par les entrées phases $\phi$1 et $\phi$2.

D'une façon générale et pour des courants sources déterminés par T7, T5, T6, T8, le niveau de détection dépend de la différence de valeur des résistances R10 et R20 d'une part, R11 et R21 d'autre part, soit :

pour un niveau de détection de 200mV, on a :

$$R10 - R20 = R11 - R21 = 10\ Kr$$

pour un niveau de détection de 50mV, on a :

$$R\ 10 - R20 = R11 - R21 = 2,5\ Kr$$

On constate que le niveau de détection est proportionnel à la différence des valeurs des résistances R10 - R20 (lorsque le potentiel de $\phi$1 décroît par rapport au potentiel de $\phi$2) et que le niveau de détection est proportionnel à la différence des valeurs des résistances R11 - R21 (lorsque le potentiel $\phi$2 décroît par rapport au potentiel de $\phi$1) .

La figure 4 représente une variante simplifiée de détecteur de signaux phases lorsqu'on ne veut détecter qu'une seule alternance. Dans ce mode de réalisation, le détecteur ne comporte qu'un seul miroir de courant (T1, T9) et une seule sortie logique (S1, commandée par le transistor T3) . Avec ce mode de réalisation, on ne détecte une différence de potentiel que lorsque $\phi$1 < $\phi$2.

Ce niveau de détection d'une différence de potentiel entre phases de l'ordre de 50 mV à 200 mV permet l'auto-amorçage de l'alternateur à basse vitesse de rotation (<1000 tours/mn) sans courant d'excitation initial.

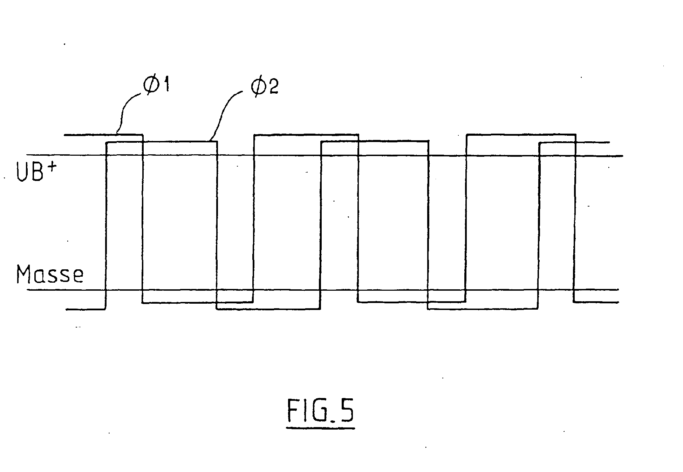

Toutefois, une telle sensibilité peut provoquer une mauvaise mise en forme des signaux phases en sortie S1 et S2 lorsque l'alternateur débite. Dans ce cas, la f.e.m. entre $\phi$1 et $\phi$2 n'est plus sinusoïdale, mais est, ainsi que l'illustre la figure 5, rectangulaire. En particulier, lorsque les deux diodes de redressement négatives (reliées à $\phi$1 et $\phi$2) sont passantes en même temps, la différence de potentiel entre $\phi$1 et $\phi$2 est théoriquement nulle. En pratique, les dispersions des diodes et les variations de courant dans ces diodes font que des variations de 200 mV sont possibles entre $\phi$1 et $\phi$2 dans la zone où la différence de potentiel entre $\phi$1 et $\phi$2 est théoriquement nulle. Les signaux obtenus en S1 et S2 ne correspondent pas à-des fronts de commutation des diodes, et il n'est pas possible de mesurer la période des signaux phases.

La solution consiste à augmenter le niveau de détection lorsque la f.e.m. entre $\phi$1 et $\phi$2 est élevée, tout en restant inférieure à toute possibilité de charge : par exemple, le changement de niveau de détection peut passer de 50 ou 200 mV à 800 mV lorsque la f.e.m. entre phases dépasse 7 volts. Cette mesure de f.e.m. peut être réalisée par le circuit de régulation du signal phase déjà utilisé dans beaucoup de régulateurs dit "multifonction".

Le générateur de courant G permet de réaliser ce changement de niveau de détection. Lorsque le régulateur détecte une amplitude des signaux entre phases supérieure à 7 volts, il rend passant le transistor M1, de sorte que la résistance R4 est mise en parallèle sur R3. En conséquence, l'augmentation de courant dans T11, T5, T6, T7, T8 entraîne l'augmentation du niveau de détection recherché : on obtient un niveau de détection de 800 mV pour des courants de 100 $\mu$A dans T11, T7, T5, T6 et T8.

**Revendications**

1. Régulateur d'alternateur polyphasé de véhicule automobile comportant des moyens pour détecter une tension entre des bornes de phase destinées à recevoir des potentiels de phase dudit alternateur, **caractérisé en ce que** lesdits moyens de détection comportent au moins un montage de transistors (T1, T9 ; T2, T10) formant miroir de courant dont les deux branches sont à une extrémité respectivement reliées à l'une et l'autre des deux bornes de phase et sont alimentées à leur autre extrémité par des transistors (T6, T7 ; T5, T8) formant sources de courant qui délivrent dans lesdites branches des courants de même intensité, les deux branches présentant en outre des résistances de valeurs différentes R10, R20 ; R11, R21, de sorte que l'un (T7, T8) des transistors des montages formant sources de courant se limite sur une valeur de courant prédéterminée (20μA) lorsqu'une différence de potentiel supérieure à un seuil donné apparaît entre les deux- bornes de phase, cette limitation entraînant le changement de niveau d'une sortie logique (S1, S2) commandée par le potentiel en un point de ladite branche entre le transistor (T7, T8) formant source de courant et le transistor (T1, T2) du montage formant miroir de courant.

2. Régulateur selon la revendication 1, **caractérisé en ce qu'**il comporte deux sorties logiques et **en ce que** lesdits montages (T1, T9 ; T2, T10 ; T6, T7 ; T5, T8) de transistors formant miroir et sources de courant sont dédoublés pour entraîner le changement de niveau de l'une ou l'autre desdites sorties logiques selon le sens de la différence de potentiel entre les bornes de phase.

3. Régulateur selon la revendication 1 ou 2, **caractérisé en ce que** le niveau de détection de la tension entre phases est lié à la différence de valeurs des résistances (R10 - R20 d'une part, R11 - R21 d'autre part) des moyens de détection).

4. Régulateur selon l'une des revendications précédentes, **caractérisé en ce que** le niveau de détection de la tension entre phases est proportionnel à la différence de valeur des résistances (R10 - R20 d'une part, R11 - R21 d'autre part) des moyens de détection).

5. Régulateur selon la revendication 1, **caractérisé en ce que** les moyens de détection ne comportent qu'un seul miroir de courant (T1, T9) et une seule sortie logique (S1, commandé par le transistor T3) pour ne détecter la f.e.m. entre φ1 et φ2 que dans un seul sens.

6. Régulateur selon l'une des revendications 1 à 5, **caractérisé en ce que** le niveau de détection que permettent lesdits moyens est de 200 mV ou inférieur.

7. Régulateur selon la revendication 6, **caractérisé en ce que** la résistance sur la branche du montage formant miroir de courant dont un potentiel commande la sortie logique est égale à 20 KΩ, la résistance sur l'autre branche étant égale à 10 KΩ.

8. Régulateur selon la revendication 6, **caractérisé en ce que** la résistance sur la branche du montage formant miroir de courant dont un potentiel commande la sortie logique est égale à 10 KΩ

9. Régulateur selon l'une des revendications 1 à 5, **caractérisé en ce que** le niveau de détection que permettent les moyens de détection est de l'ordre de 50 mV.

10. Régulateur selon la revendication 9, **caractérisé en ce que** la résistance sur la branche du montage formant miroir de courant dont un potentiel commande la sortie logique est égale à 5 KΩ, la résistance sur l'autre branche étant égale à 2,5 KΩ.

11. Régulateur selon la revendication 9, **caractérisé en ce que** la résistance sur la branche du montage formant miroir de courant dont un potentiel commande la sortie logique est égale à 2,5 KΩ.

12. Régulateur selon une des revendications précédentes, **caractérisé en ce qu'**il comporte des moyens (M1, R4) pour modifier le niveau de détection de la tension entre les bornes de phase lorsque le potentiel reçu sur lesdites bornes est supérieur à une valeur donnée.

**Claims**

1. Motor vehicle polyphase alternator regulator, comprising means for detecting a voltage between phase terminals which are designed to receive phase potentials of the said alternator, **characterised in that** the said detection means comprise at least one assembly of transistors (T1, T9; T2, T10) which form a current mirror, the two branches of which are connected respectively at one end to one and the other of the two phase terminals, and are supplied at their other end by transistors (T6, T7; T5, T8) which form current sources which supply to the said branches currents of the same intensity, the two branches additionally having resistors (R10, R20; R11, R21) with different values, such that one (T7, T8) of the transistors of the assemblies which form current sources is limited to a prede-termined current value (20μA) when a difference of potential greater than a given threshold appears between the two phase terminals, this limitation giving rise to the change of level of a logic output (S 1, S2) which is controlled by the potential at a point of the said branch between the transistor (T7, T8) which forms a current source and the transistor (T1, T2) of the assembly which forms a current mirror.

2. Regulator according to claim 1, **characterised in that** it comprises two logic outputs, and **in that** the said assemblies (T1, T9; T2, T10; T6, T7; T5, T8) of transistors which form a mirror and current sources are split in order to give rise to the change of level of one or the other of the said logic outputs, according to the direction of the difference of potential between the phase terminals.

3. Regulator according to claim 1 or 2, **characterised in that** the level of detection of the voltage between phases is associated with the difference in values of the resistors (R10 - 20 on the one hand, R11 - R21 on the other hand) of the detection means.

4. Regulator according to one of the preceding claims, **characterised in that** the level of detection of the voltage between phases is proportional to the difference in value of the resistors (R10 - R20 on the one hand, R11 - R21 on the other hand) of the detection means.

5. Regulator according to claim 1, **characterised in that** the detection means comprise only a single current mirror (T1, T9) and a single logic output (S1, controlled by the transistor T3), to detect the electromotive force between φ1 and φ2 only in a single direction.

6. Regulator according to one of claims 1 to 5, **characterised in that** the level of detection which the said means permit is 200 mV or less.

7. Regulator according to claim 6, **characterised in that** the resistance on the assembly branch which forms a current mirror, a potential of which controls the logic output, is equal to 20 KΩ, the resistance on the other branch being equal to 10 kΩ.

8. Regulator according to claim 6, **characterised in that** the resistance on the assembly branch which forms a current mirror, a potential of which controls the logic output, is equal to 10 kΩ.

9. Regulator according to one of claims 1 to 5, **characterised in that** the level of detection which the detection means permit is approximately 50 mV.

10. Regulator according to claim 9, **characterised in that** the resistance on the assembly branch which forms a current mirror, a potential of which controls the logic output, is equal to 5 KΩ, the resistance on the other branch being equal to 2.5 kΩ.

11. Regulator according to claim 9, **characterised in that** the resistance on the assembly branch which forms a current mirror, a potential of which controls the logic output, is equal to 2.5 kΩ.

12. Regulator according to one of the preceding claims, **characterised in that** it comprises means (M1, R4) for modifying the level of detection of the voltage between the phase terminals when the potential received on the said terminals is greater than a given value.

**Patentansprüche**

1. Regler eines Mehrphasen-Wechselstromgenerators für Kraftfahrzeuge mit Mitteln zur Erfassung einer Spannung zwischen Phasenklemmen, die dazu bestimmt sind, Phasenpotenziale des besagten Wechselstromgenerators zu empfangen, **dadurch gekennzeichnet, dass** die besagten Erfassungsmittel wenigstens eine als Stromspiegel dienende Transistorenschaltung (T1, T9; T2, T10) umfassen, deren zwei Stränge an einem Ende mit der einen bzw. der anderen der beiden Phasenklemmen verbunden sind und die an ihrem anderen Ende durch als Stromquellen dienende Transistoren (T6, T7; T5, T8) gespeist werden, die in den besagten Strängen Ströme mit der gleichen Stromstärke abgeben, wobei die beiden Stränge außerdem Widerstände mit unterschiedlichen Werten (R10, R20; R11, R21) aufweisen, so dass einer (T7, T8) der Transistoren der als Stromquellen dienenden Schaltungen sich auf einen vorbestimmten Stromwert (20 μA) begrenzt, wenn ein Potenzialunterschied, der größer als ein gegebener Schwellenwert ist, zwischen den beiden Phasenklemmen auftritt, wobei diese Begrenzung die Pegeländerung eines logischen Ausgangs (S1, S2) zur Folge hat, der durch das Potenzial an einem Punkt des besagten Strangs zwischen dem als Stromquelle dienenden Transistor (T7, T8) und dem Transistor (T1, T2) der als Stromspiegel dienenden Schaltung gesteuert wird.

2. Regler nach Anspruch 1, **dadurch gekennzeichnet, dass** er zwei logische Ausgänge umfasst und d a s s die besagten Schaltungen von als Stromspiegel und als Stromquelle dienenden Transistoren (T1, T9; T2, T10; T6, T7; T5, T8) gedoppelt sind, um die Pegeländerung des einen oder des anderen der besagten logischen Ausgänge je nach der Richtung des Potenzialunterschieds zwischen den Phasenklemmen herbeizuführen.

3. Regler nach Anspruch 1 oder 2, **dadurch gekennzeichnet, dass** der Erfassungspegel für die Zwischenphasenspannung mit der Dififerenz der Werte der Widerstände (R10 - R20 einerseits, R11 - R21 andererseits) der Erfassungsmittel zusammenhängt.

4. Regler nach einem der vorangehenden Ansprüche, **dadurch gekennzeichnet, dass** der Erfassungspegel für die Zwischenphasenspannung proportional zur Dififerenz der Werte der Widerstände (R10 - R20 einerseits, R11 - R21 andererseits) der Erfassungsmittel ist.

5. Regler nach Anspruch 1, **dadurch gekennzeichnet, dass** die Erfassungsmittel nur einen einzigen Stromspiegel (T1, T9) und einen einzigen logischen Ausgang (S1, gesteuert durch den Transistor T3) umfassen, um die elektromotorische Kraft zwischen ϕ1 und ϕ2 nur in einer Richtung zu erfassen.

6. Regler nach einem der Ansprüche 1 bis 5, **dadurch gekennzeichnet, dass** der Erfassungspegel, den die besagten Mittel ermöglichen, kleiner oder gleich 200 mV ist.

7. Regler nach Anspruch 6, **dadurch gekennzeichnet, dass** der Widerstand an dem Strang der als Stromspiegel dienenden Schaltung, von dem ein Potenzial den logischen Ausgang steuert, gleich 20 kΩ ist, während der Widerstand an dem anderen Strang gleich 10 kΩ ist.

8. Regler nach Anspruch 6, **dadurch gekennzeichnet, dass** der Widerstand an dem Strang der als Stromspiegel dienenden Schaltung, von dem ein Potenzial den logischen Ausgang steuert, gleich 10 kΩ ist.

9. Regler nach einem der Ansprüche 1 bis 5, **dadurch gekennzeichnet, dass** der Erfassungspegel, den die Ertassungsmittel ermöglichen, in einer Größenordnung von 50 mV liegt.

10. Regler nach Anspruch 9, **dadurch gekennzeichnet, dass** der Widerstand an dem Strang der als Stromspiegel dienenden Schaltung, von dem ein Potenzial den logischen Ausgang steuert, gleich 5 kΩ ist, während der Widerstand an dem anderen Strang gleich 2,5 kΩ ist.

11. Regler nach Anspruch 9, **dadurch gekennzeichnet, dass** der Widerstand an dem Strang der als Stromspiegel dienenden Schaltung, von dem ein Potenzial den logischen Ausgang steuert, gleich 2,5 kΩ ist.

12. Regler nach einem der vorangehenden Ansprüche, **dadurch gekennzeichnet, dass** er Mittel (M1, R4) umfasst, um den Erfassungspegel für die Spannung zwischen den Phasenklemmen zu verändern, wenn das an den besagten Klemmen empfangene Potenzial größer als ein gegebener Schwellenwert ist.

FIG.1

FIG.2

9

FIG.3

FIG.4

FIG.5

**EP 0 926 810 B1**

**Documents brevets cités dans la description**

- FR 2343255
- FR 2730359
- FR 2678070